Europäisches Patentamt

European Patent Office

Office européen des brevets

(11) Veröffentlichungsnummer: **0 236 807**
**A2**

(12) **EUROPÄISCHE PATENTANMELDUNG**

(21) Anmeldenummer: **87102318.0**

(22) Anmeldetag: **18.02.87**

(51) Int. Cl.⁴: **H01J 37/04** , H01J 49/46 ,
G01R 31/28

(30) Priorität: **07.03.86 DE 3607553**

(43) Veröffentlichungstag der Anmeldung:
**16.09.87 Patentblatt 87/38**

(84) Benannte Vertragsstaaten:
**AT BE CH DE FR GB IT LI LU NL SE**

(71) Anmelder: **Siemens Aktiengesellschaft Berlin
und München
Wittelsbacherplatz 2
D-8000 München 2(DE)**

(72) Erfinder: **Plies, Erich Dr. rer. nat.
Deisenhofener Strasse 79 c
D-8000 München 90(DE)**

(54) **Spektrometerobjektiv für die Korpuskularstrahl-Messtechnik.**

(57) Das erfindungsgemäße Spektrometerobjektiv für die Kopuskularstrahl-Meßtechnik besteht aus einer kurz-brennweitigen Objektivlinse (OL) mit integriertem elektrostatischen Gegenfeldspektrometer und einer einstufigen, innerhalb der Magnetlinse angeordneten Ablenkeinheit (DS). Da die Ablenkung innerhalb des Spektrometerobjektivs erfolgt, kann der Raum für die in konventionellen Rastermikroskopen verwendeten zweistufigen Ablenksysteme zwischen Kondensor-und Objektivlinse eingespart werden. Um Ablenkungen der von dem primären Korpuskularstrahl (PE) auf einer Probe (IC) ausgelösten Sekundärkorpuskeln (SE) zu vermeiden, sind die mit Hilfe der Ablenkeinheit (DS) erzeugten nahezu homogenen elektrischen und magnetischen Ablenkfelder räumlich so zueinander orientiert, daß deren Feldvektoren senkrecht aufeinander und jeweils senkrecht auf dem Geschwindigkeitsvektor der von der Probe (IC) abgesaugten Sekundärkorpuskeln (SE) stehen.

FIG 1

EP 0 236 807 A2

## Spektrometerobjektiv für die Korpuskularstrahl-Meß-technik

Die Erfindung betrifft ein Spektrometerobjektiv für die Korpuskularstrahl-Meßtechnik nach dem Oberbegriff des Patentanspruchs 1.

Für quantitative Potentialmessungen an Knotenpunkten und Leiterbahnen in hochintegrierten Schaltungen werden gegenwärtig konventionelle, mit Strahlaustastsystemen und Gegenfeld-Spektrometern ausgerüstete Raster-Elektronenmikroskope eingesetzt. Mit modifizierten Raster-Elektronenmikroskopen lassen sich genügend feine Elektronensonden zur Untersuchung höchstintegrierter Schaltungen mit Strukturen im Sub-Mikrometerbereich allerdings nicht erzeugen, da diese Geräte zur Vermeidung von Strahlenschäden und Aufladungen der zumeist auf nicht-oder schlechtleitenden Trägersubstanzen angeordneten Bauelemente bei niedrigen Beschleunigungsspannungen betrieben werden müssen. Eine deutliche Verbesserung der im wesentlichen durch den axialen Farbfehler der Objektivlinse und die Elektron-Elektron-Wechselwirkung (Boersch-Effekt) begrenzten Ortsauflösung ist nur durch einen kurzen elektronenoptischen Strahlengang mit wenigen Strahlüberkreuzungspunkten und eine Objektivlinse kurzer Brennweite erreichbar. Der Einsatz kurzbrennweitiger Objektivlinsen zur Reduktion der im wesentlichen durch die Brennweite bestimmten chromatischen und sphärischen Bildfehler scheiterte bisher am Aufbau konventioneller Elektronenstrahl-Meßgeräte, bei denen zwischen Objektivlinse und Probe ein Sekundärelektronen-Spektrometer angeordnet ist. Erst durch die Entwicklung von Objektivlinsen mit integriertem Sekundärelektronen-Spektrometer, sog. Spektrometerobjektiven, konnte mit dem Arbeitsabstand die Aberration der Objektivlinse und damit der Sondendurchmesser auf der Probe reduziert werden. Ein solches Spektrometerobjektiv ist aus der Veröffentlichung von Kawamoto "Electron Beam Tester with In the Lens Analyzer", erschienen in den Proceedings of the Symposium on Electron-Beam-Testing, 9.-10. Nov. 1984, Osaka, Japan, S. 69-72 bekannt. Bei dieser Anordnung handelt es sich um eine magnetische Objektivlinse kurzer Brennweite, in die ein aus Absaug-und Gegenfeldelektrode bestehender Parallelplatten-Analysator integriert wurde. Ein winkelunabhängiger Nachweis der auf der Probe ausgelösten und in einen größeren Raumwinkelbereich emittierten Sekundärelektronen ist mit diesem Spektrometerobjektiv allerdings nicht möglich, so daß der hierdurch bedingte Meßfehler die mögliche Potentialauflösung begrenzt.

Ein Spektrometerobjektiv mit integriertem magnetischen Ablenksystem wurde in der deutschen Patentanmeldung P 35 21 464.3 (VPA 85 P 8032 DE) vorgeschlagen. Bei dieser Anordnung erfolgt die Ablenkung des primären Elektronenstrahls innerhalb des Spektrometerobjektivs, so daß der Raum für die in konventionellen Rasterelektronenmikroskopen eingesetzen zweistufigen Ablenksysteme zwischen Kondensor-und Objektivlinse eingespart und der mit der Länge des Strahlengangs wachsende Einfluß des lateralen Boersch-Effektes auf den Sondendurchmesser reduziert werden kann. Da sowohl die Primärelektronen als auch die in Richtung der Gegenfeldelektrode beschleunigten Sekundärelektronen im Feld der integrierten Ablenkeinheit abgelenkt werden, ist ein winkelunabhängiger Nachweis näherungsweise nur noch für die in Richtung der Symmetrieachse der Sekundärelektronenkeule emittierten Teilchen möglich.

Der Erfindung liegt die Aufgabe zugrunde ein Spektrometerobjektiv anzugeben, bei dem die Nachweisempfindlichkeit für Sekundärkorpuskeln durch eine in die Objektivlinse integrierte Ablenkeinheit nicht verändert wird. Es soll insbesondere sichergestellt sein, daß die Sekundärkorpuskeln im Feld der Ablenkeinheit nicht abgelenkt werden. Weiterhin soll ein winkelunabhängiger Nachweis der Sekundärkorpuskeln bei unabgelenktem Primärstrahl gewährleistet sein.

Diese Aufgabe wird erfindungsgemäß durch ein Spektrometerobjektiv nach Patentanspruch 1 gelöst.

Der mit der Erfindung erzielbare Vorteil besteht insbesondere darin, das die Orts-und Potentialauflösung in einem Korpuskularstrahl-Meßgerät, beispielsweise einem Elektronenstrahl-Meßgerät, auch bei hohen Sondenströmen deutlich gesteigert werden kann. Es ist außerdem sichergestellt, das die Nachweisempfindlichkeit des Detektorsystems für Sekundärkorpuskeln nicht durch die innerhalb des Spektrometerobjektivs integrierte Ablenkeinheit beeinträchtigt wird.

Die Patentansprüche 2 bis 17 sind auf bevorzugte Ausgestaltungen und Weiterbildungen der Erfindung gerichtet.

Das erfindungsgemäße Spektrometerobjektiv wird nachfolgend anhand der Zeichnungen erläutert. Dabei zeigen:

Fig. 1 und 5 Ausführungsbeispiele erfindungsgemäßer Spektrometerobjektive,

Fig. 2 einen Schnitt durch ein elektrostatisches Ablenkelement,

Fig. 3 einen Schnitt durch eine erfindungsgemäße Ablenkeinheit,

Fig. 4 den Verlauf der elektrischen und magnetischen Ablenkfeldstärke auf der optischen Achse eines erfindungsgemäßen Spektrometerobjektivs.

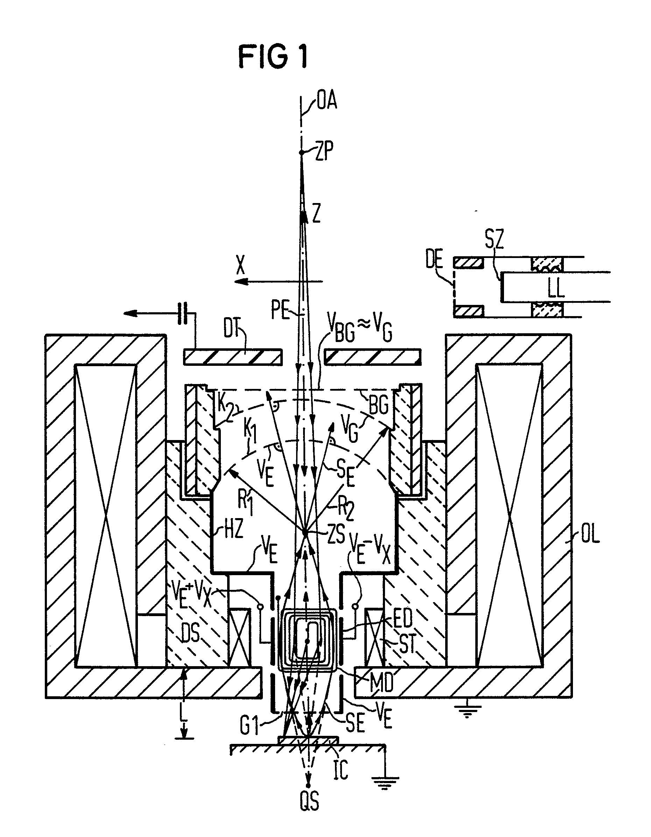

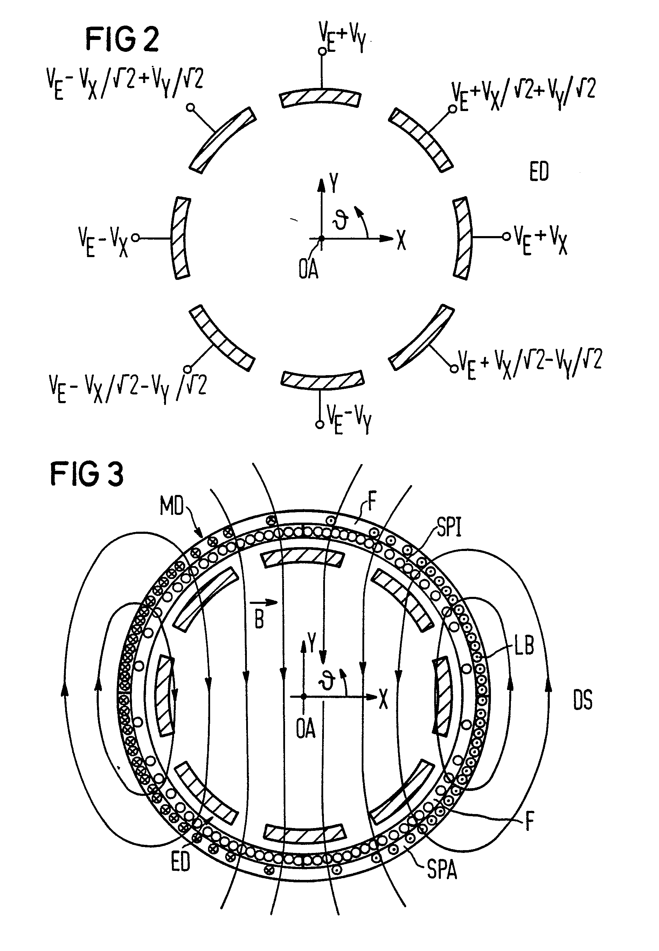

Das in Fig. 1 dargestellte Ausführungsbeispiel eines erfindungsgemäßen Spektrometerobjektivs für die Elektronenstrahl-Meßtechnik besteht aus einer kurzbrennweitigen, weitgehend asymmetrischen Objektivlinse OL mit integriertem elektrostatischen Gegenfeldspektrometer und einer innerhalb der Objektivlinse symmetrisch zur optischen Achse OA angeordneten einstufigen Ablenkeinheit DS. Das aus Objektivlinse OL, Spektrometer und Ablenkeinheit DS bestehende System bildet die Komponente der elektronenoptischen Säule eines Elektronenstahlmeßgerätes, mit der die von einer Hochstrom-Elektronenquelle ausgehenden Primärelektronen fokussiert und abgelenkt und die auf der Probe IC, beispielsweise einer integrierten Schaltung, ausgelösten Sekundärelektronen SE in einen auf der optischen Achse OA liegenden Punkt ZS abgebildet werden. Zur Erzeugung einer feinen Elektronensonde mit kleinem Strahlquerschnitt ($d_{PE} \leq 0,1$ μm) bildet man die Elektronenquelle oder deren durch Kondensorlinsen verkleinertes Zwischenbild ZP mit Hilfe des Spektrometerobjektivs nochmals verkleinert auf die in unmittelbarer Nähe der hinteren Brennebene der Magnetlinse OL angeordneten Probe IC ab. Die Positionierung des Primärelektronenstahls PE auf einen nicht näher bezeichneten Punkt der Probe IC bzw. dessen zeilenförmige Ablenkung über die Probenoberfläche erfolgt mit Hilfe der aus magnetischen und elektrischen Ablenkelementen MD bzw. ED bestehenden Ablenkeinheit DS deren Ablenkhauptebene in etwa mit der bildseitigen Hauptebene des Spektrometerobjektivs zusammenfällt. Da nur die Primärelektronen PE nicht aber die von der Probe IC abgesaugten Sekundärelektronen SE eine Ablenkung erfahren sollen, müssen die von der Ablenkeinheit DS innerhalb der Objektivlinse OL erzeugten und über einen größeren Raumbereich homogenen elektrischen und magnetischen Ablenkfelder nach Art eines Wien'schen Filters so räumlich zueinander orientiert sein, daß deren Feldvektoren $\vec{E}$ bzw. $\vec{B}$ und der Geschwindigkeitsvektor $\vec{V}_{SE}$ der Sekundärelektronen SE im Bereich der Ablenkeinheit DS jeweils nahezu senkrecht aufeinander stehen. Die im Feld der Ablenkeinheit DS auf die Sekundärelektronen SE wirkende Lorentzkraft verschwindet allerdings nur dann, wenn der Quotient aus dem Betrag $|\vec{E}|$ der elektrischen und den Betrag $|\vec{B}|$ der magnetischen Feldstärke konstant und gleich dem Betrag $|\vec{V}_{SE}|$ der Geschwindigkeit der Sekundärelektronen SE gewählt wird. Ein Ausführungsbeispiel einer Ablenkeinheit, die die genannten Bedingungen erfüllt und die sich sehr leicht der in Fig. 1 gezeigten Ausführungsform des erfindungsgemäßen Spektrometerobjektivs anpassen läßt ist in den Fig. 2 und 3 dargestellt.

Zum Nachweis der am Auftreffpunkt der Primärelektronen PE ausgelösten und in einen großen Raumwinkelbereich (cos-Verteilung der Emissionswinkel) oberhalb der Probe IC emittierten niederenergetischen Sekundärelektronen SE ($\vec{E}_{SE} < 50$ eV) werden diese im elektrischen Feld einer auf hohem positiven Potential $V_E$ zwischen etwa 0,5 und 5 kV, insbesondere 2 kV liegenden Netzelektrode G1 abgesaugt und in Richtung der optischen Achse OA beschleunigt. Die nun ebenfalls hochenergetischen Sekundärelektronen SE ($E_{SE} = 0,5-5$ keV) durchlaufen diese ebene und unmittelbar oberhalb der Probe IC angeordnete Netzelektrode G1 und gelangen in das fokussierende Magnetfeld der Objektivlinse OL, in dem sie in einen auf der optischen Achse OA innerhalb des Spektrometerobjektivs liegenden Punkt ZS abgebildet werden. Die Lage dieses Fokussierungspunktes ZS, der als reeles Zwischenbild der unterhalb der Probe liegenden virtuellen Sekundärelektronenquelle QS zu interpretieren ist, wird bestimmt von der Höhe der Absaugspannung $V_E$ und der von der Primär elektronenenergie abhängigen Magnetfeldstärke zwischen den Polschuhen der Objektivlinse OL. Die virtuelle Quelle QS ist hierbei durch den kleinsten Kaustik-Querschnitt aller virtuellen Sekundärelektronen-Trajektorien unterhalb der Probe IC definiert. Die Fokussierung der Sekundärelektronen SE im Feld der Objektlinse OL ist erst durch deren Beschleunigung auf hohe kinetische Energien ($E_{SE} = 0,5-5$ keV) gewährleistet, da nur dann die relative Energiebreite $\Delta E/\vec{E}$ ($\vec{E}$ = mittlere kinetische Energie der Sekundärelektronen SE) soweit reduziert wird, daß die jeweiligen Bildweiten der am Meßpunkt mit unterschiedlichen Energien emittierten Sekundärelektronen SE nahezu gleich sind. Da auch die Primärelektronen PE die Objektivlinse OL bei hohen Absaugspannungen $V_E$ mit hohen Energien durchlaufen, wird auch der nachteilige Einfluß des lateralen Boersch-Effektes auf den Sondendurchmesser in diesem Teil des elektronenoptischen Strahlenganges reduziert.

Die Energieanalyse der Sekundärelektronen SE erfolgt innerhalb oder oberhalb der Objektivlinse OL in einem kugelsymmetrischen elektrischen Gegenfeld, das in dem Raumbereich zwischen zwei nahezu halbkugelförmigen, auf unterschiedlichem Potential liegenden Netzelektroden K1 und K2 aufgebaut wird. Derartige Elektrodenanordnungen sind beispielsweise aus der US-PS· 4 464 571 bekannt. Während die untere Netzelektrode K1 auf dem gleichen Potential $V_E$ wie Absaugelektrode G1 liegt, werden an die als Gegenfeld-Gitter wirkende obere Netzelektrode K2 typischer Weise Spannungen $V_G$ zwischen etwa -15 Volt und + 15 Volt angelegt. Oberhalb der das Gegenfeld aufbauenden Elektrodenanordnung K1, K2 kann noch ein Abschirmgitter BG vorgesehen sein, das mit etwa der gleichen Spannung $V_{BG}$ wie die Netzelektrode K2 beaufschlagt wird ($V_{BG} \approx V_G$).

Zum Nachweis der Sekundärelektronen SE ist innerhalb des erfindungsgemäßen Spektrometerobjektives ein konzentrisch zur optischen Achse OA angeordneter ringförmiger Detektor DT vorgesehen. Hierfür besonders geeignet sind beispielsweise Halbleiterdetektoren, Channel-Plates oder Metallplatten mit Elektronenfallen. Außer diesem ringförmigen Detektor DT kann oberhalb des Spektrometerobjektives noch ein zweiter konventioneller, beispielsweise aus Absaugelektrode DE, Szintillator SZ und Lichtleiter LL bestehender Detektor zum Nachweis der in Richtung der optischen Achse OA emittierten Sekundärelektronen SE vorgesehen sein.

Ein winkelunabhängiger Nachweis der Sekundärelektronen SE ist bei unabgelenktem Primärstrahl PE nur dann gewährleistet, wenn deren Trajektorien parallel zu den Feldlinien des elektrischen Gegenfeldes und damit senkrecht zur Oberfläche der nahzu halbkugelförmigen Netzelektroden K1 und K2 verlaufen. Dieser Bedingung kann Rechnung getragen werden, wenn man den virtuellen Quellpunkt QS der Sekundärelektronen SE in das Zentrum ZS des sphärischen Gegenfeldes, d. h. in den auf der optischen Achse OA liegenden gemeinsamen Mittelpunkt der kugelsymmetrischen Netzelektroden K1 und K2 abbildet. Gleichzeitig muß dieses Zwischenbild ZS genügend weit oberhalb der Polschuhe und der Ablenkeinheit DS in einem feldfreien Raum liegen, um Lamor-Drehungen und die durch elektrische Felder verursachten Störungen der Bahnbewegung der Sekundärelektronen SE nach Durchlaufen des Punktes ZS zu vermeiden. Die Fokussierung der Sekundärelektronen SE in einen auf der optischen Achse OA oberhalb der Ablenkeinheit DS liegenden Punkt ZS ist hierbei um so besser möglich, je kleiner die Energie der Primärelektronen PE und je höher das die Sekundärelektronen SE beschleunigende Absaugpotential $V_E$ der Netzelektrode K1 ist. Zur Erzeugung eines von elektrischen Feldern freien Raumes in der Umgebung des Sekundärelektronen-Zwischenbildes ZS ist ein aus drei Teilen bestehender und symmetrisch zur optischen Achse OA angeordneter Hohlzylinder HZ innerhalb der Objektivlinse OL vorgesehen. Während der obere Teil dieses sich im Bereich der Polschuhe verjüngenden Hohlzylinder leitend mit der kugelsymmetrischen Netzelektrode K1 verbunden ist, wird dessen teilweise aus der Objektivlinse OL herausragender unterer Teil probenseitig von der ebenen Absaugelektrode G1 abgeschlossen. In den mittleren Teil dieses als Faraday-Käfig wirkenden Hohlzylinders HZ wird erfindungsgemäß ein elektrostatischer Achtpolablenker integriert, indem man diesen Teil der Röhre in z-Richtung und azimutal entsprechend dem in Fig. 2 dargestellten Ausführungsbeispiel unterteilt und die acht Einzelelektroden mit geeigneten Potentialen $V_i$ (i = 1-8) belegt. Mit diesen elektrischen Ablenkelement kann man durch eine Potenialbelegung der Form

$$V_i = V_E + V_x \cos\vartheta_i + V_y \sin\vartheta_i \quad 1)$$

wobei i und $\vartheta_i$ (i = 1-8) die Nummern bzw. den Azimut der Mitte der i-ten Elektrode und $V_x$ bzw. $V_y$ zeitabhängige Ablenkspannungen bezeichnen, ein rein einzähliges elektrostatisches Dipolfeld mit guter Homogenität in einer Ebene senkrecht zur optischen Achse OA aufbauen. Auf den Stigmator ST zur Kompensation des axialen Astigmatismus kann verzichtet werden, wenn man die Elektroden des Achtpolablenkers mit geeigneten Zusatzspannungen beaufschlagt.

Um eine Ablenkung der im Feld der Netzelektrode K1 auf Energien von $E_{kin} \approx eV_E$ beschleunigten Sekundärelektronen SE zu vermeiden, überlagert man dem elektrischen Ablenkfeld (in Fig. 1 in -x-Richtung orientiert) ein senk recht dazu stehendes magnetisches Ablenkfeld (in Fig. 1 in -y-Richtung orientiert). Die Feldstärken $E_o$ bzw. $B_o$ Sekundärelektronen SE wirkende Lorentzkraft gerade verschwindet (d. h. es muß gelten $E_o / B_o$ = konstant).

Als magnetisches Ablenkelement MD verwendet man vorteilhafterweise ein nach Art einer flexiblen Leiterplatte hergestelltes Sattelspulensystem. Diese platzsparenden und beispielsweise aus der Veröffentlichung von K.H. Herrmann et al."The Design of Compact Deflection Coils and their Application to a Minimum Exsposure System", Proc. of the 6th Europ. Congr. on Electron Microscopy (Jerusalem, 1976) S. 342-343 bekannten Sattelspulen werden zu Paaren zusammengefaßt und als flexible Folie F mit den darin eingebetteten Leiterbahnen LB (Spulenwicklungen) außen über das elektrostatische Ablenkelement ED gebogen (siehe Fig. 3). Der zwischen dem elektrostatischen Ablenkelement ED und den Ablenkspulen SPI, SPA liegende Isolator wurde aus Gründen der Übersichtlichkeit nicht in den Fig. 1 und 3 dargestellt. Die Windungsverteilung innerhalb des Spulensystems sollte hierbei so gewählt werden, daß die Ablenkeinheit ein möglichst homogenes Magnetfeld in einer senkrecht zur optischen Achse OA liegenden Ebene erzeugt.

Zur Herleitung der Abgleichbedingung für die nach Art eines Wien'schen Filters aufgebaute Ablenkeinheit DS soll auf der optischen Achse OA ein elektrisches Ablenkfeld

$$\vec{E} = E_x (O,O,z) \, \vec{e}_x + E_y (O,O,z) \, \vec{e}_y \quad 2a)$$

und ein magnetisches Ablenkfeld

4

$$\vec{B} = B_x(0,0,z) \ \vec{e}_x + B_y(0,0,x) \ \vec{e}_y \quad 2b)$$

angenommen werden. In dieser von der Ablenkeinheit erzeugten Feldverteilung wirkt auf ein geladenes Teilchen der Ladung q und der Geschwindigkeit $\vec{V}$ die Lorentzkraft

$$\vec{F} = q \ ( \ \vec{E} + \vec{V} \times \vec{B} \ ) \quad 3)$$

Gleichung 3) vereinfacht sich für Elektronen, deren Geschwindigkeit nur eine Komponente in z-Richtung aufweist ( $\vec{V} = v_z \bullet \vec{e}_z$

$$\vec{F} = - \ e \left\{ \left[ E_x(0,0,z) - v_z \ B_y(0,0,z) \right] \ \vec{e}_x + \left[ E_y(0,0,z) + v_z B_x(0,0,z) \right] \ \vec{e}_y \right\} \quad 4)$$

Die Annahme $\vec{V} = v_z \ \vec{e}_z = v_{SE} \ \vec{e}_z$ ist insbesondere für die von der Probe IC im Feld der Netzelektrode K1 abgesaugten und in Richtung der optischen Achse OA beschleunigten Sekundärelektronen SE erfüllt, die das Ablenkfeld mit nahezu derselben Geschwindigkeit (nicht relativistische Näherung)

$$v_{SE} = \left[ 2 \ (E_0 + eV_E) \ m^{-1} \right]^{1/2} \approx \left[ 2 \ eV_E m^{-1} \right]^{1/2} \quad 5)$$

durchlaufen (Startenergie $E_0 < 50$ eV, Energiegewinn $eV_E$ im Feld der Absaugelektrode G1 typischerweise $eV_E = 0.5$-5 kev). Sekundärelektronen SE der Geschwindigkeit $\vec{V} = v_{SE} \ \vec{e}_z$ erfahren im Feld der Ablenkeinheit DS keine Ablenkung wenn $\vec{F}_{SE} = 0$ gilt. Aus Gleichung 4) erhält man damit

$$\vec{F}_{SE} = - \ e \left\{ \left[ E_x(0,0,z) - v_{SE} \ B_y(0,0,z) \right] \ \vec{e}_x + \left[ E_y(0,0,z) + v_{SE} \ B_x(0,0,z) \right] \ \vec{e}_y \right\} \quad 6)$$

woraus unmittelbar die Abgleichbedingung

$E_x(0,0,z) \ / \ B_y(0,0,z) = v_{SE}$

$E_y(0,0,z) \ / \ B_x(0,0,z) = -v_{SE} \quad 7)$

folgt. Zur Berechnung der auf ein Primärelektron wirkenden Lorentzkraft in einem elektrischen und magnetischen Ablenkfeld nach Gleichung 2a/2b) ist in Gleichung 4) $v_z$ durch $v_z = -v_{PE}$ mit

$$v_{PE} = \left[ 2e \ (V_B + V_E) \ m^{-1} \right]^{1/2} \quad 8)$$

zu ersetzen, wobei $eV_B$ die Energie der Primärelektronen PE auf der Probe IC und $e(V_B + V_E)$ die Energie des Sekundärelektronen SE im Bereich des Ablenkfeldes bezeichnet. Aus Gleichung 4) erhält man unter Berücksichtigung der Abgleichbedingung 7) und 8)

$$\vec{F}_{PE} = - e \left[ 1 + (1 + V_B/V_E)^{1/2} \right] \cdot$$

$$\left[ E_x \ (0,0,z) \ \vec{e}_x + E_y \ (0,0,z) \ \vec{e}_y \right] \qquad 9)$$

d. h. der Ablenkung der Primärelektronen PE ist mehr als doppelt so stark als in einem rein elektrostatischen Ablenkfeld.

In Fig. 3 ist eine erfindungsgemäße Ablenkeinheit DS im Schnitt senkrecht zur optischen Achse OA dargestellt. Sie besteht aus dem elektrostatischen Achtpolablenker nach Fig. 2, einer Isolatorschicht und zwei nach Art einer flexiblen Leiterplatte hergestellten Sattelspulenpaaren SPI bzw. SPA, die den konzentrisch zur optischen Achse OA angeordneten zylindrischen Achtpolablenker ED vollständig umfassen. Die zwischen den elektrischen und magnetischen Ablenkelementen liegende Isolatorschicht ist in Fig. 3 aus Gründen der Übersichtlichkeit nicht dargestellt. Zur Erzeugung eines homogenen magnetischen Ablenkfeldes B senkrecht zur optischen Achse OA werden vorzugsweise Sattelspulen mit einer Windungsverteilung dN/d$\vartheta$

dN/d$\vartheta$ = konst cos$\vartheta$ bzw.

dN/d$\vartheta$ = konst sin$\vartheta$

eingesetzt, wobei dN/d$\vartheta$ die Zahl der Windungen pro Win-keleinheit und $\vartheta$ den in einer senkrecht zur optischen Achse OA liegenden Ebenen gemessenen Azimutwinkel bezeichnet. Das von dem äußeren Sattelspulenpaar SPA erzeugte magnetische Ablenkfeld B wurde in Fig. 3 dargestellt. Die Stromrichtung in den einzelnen Leiterbahnen LB ist hierbei wie üblich durch Kreuze und Punkte innerhalb des Leiterquerschnittes angedeutet. Eine ähnliche Feldverteilung, allerdings in einer dazu senkrechten Richtung kann mit Hilfe des inneren Sattelspulenpaares SPI aufgebaut werden.

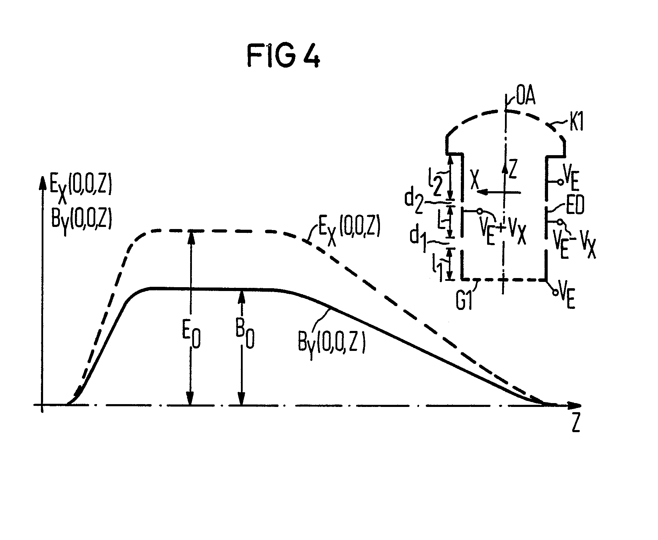

Die Abgleichbedingung für das nach Art eines Wien'schen Filters aufgebaute Ablenkeinheit DS muß nicht nur für die Maximalwerte der elektrischen und magnetischen Feldstärke $E_o$ bzw. $B_o$ sondern auch innerhalb der Anordnung längs der optischen Achse OA erfüllt sein. Wie in Fig. 4 dargestellt, fällt sowohl das elektrische als auch das magnetische Ablenkfeld $E_x$ (0,0,z) bzw. $B_y$ (0,0,z) in Richtung der Probe IC - schneller als in Richtung der Zwischenbildes ZS ab. Dieser unsymmetrische Feldverlauf in Richtung der optischen Achse OA ist eine Folge des Aufbaus des Spektrometerobjektivs, bei dem das Absaugnetz G1 und das untere Kugelnetz K1 unterschiedlichen Abstand zum elektrischen Ablenkelement ED aufweisen und das magnetische Ablenkelement MD in der Nähe der Polschuhe angeordnet ist. Zur Anpassung des elektrischen Ablenkfeldes an einen vorgegebenen magnetischen Ablenkfeldverlauf, kann die Länge $l_1$, $l_2$, L der drei Teile des konzentrisch zur optischen Achse OA angeordneten Hohlzylinders HZ und/oder deren gegenseitiger Abstand $d_1$, $d_2$ so aufeinander abgestimmt werden, daß die Bedingung

$E_x$ (0,0,z) / $B_y$ (0,0,z) $\approx$ konst = $E_o$ $B_o$ = $v_{SE}$ ($V_E$

erfüllt wird.

Ein winkelunabhängiger Nachweis der Sekundärelektronen SE ist bei abgelenktem Primärelektronenstahl PE nur noch näherungsweise gewährleistet, da das Zwischenbild ZS der Sekundärelektronen SE aufgrund der abbildenden Eigenschaften der Objektivlinse OL in diesen Fällen außerhalb der optischen Achse OA liegt und nicht mehr mit den Zentrum des kugelsymmetrischen Gegenfeldes zusammenfällt. Der aus dieser prinzipiell nicht korrigierbaren und allein durch das Feld der Objektivlinse OL verursachten Verschiebung des Sekundärelektronenfokus ZS resultierende Meßfehler ist in der Praxis inbesondere bei quantitativen Potentialmessungen an Knotenpunkten einer hochintegrierten Schaltung nicht vom besonderen Nachteil, da man die Probe IC mit Hilfe feinmechanischer Einrichtungen bis auf etwa 1 $\mu$m genau relativ zur optischen Achse OA ausrichten kann. Die dann eventuell noch mit der Ablenkeinheit vorzunehmende Feinpositionierung des Primärelektronenstrahles auf dem Meßpunkt erfordert nur kleine Ablenkungen, so daß das Zwischenbild ZS der Sekundärelektronen SE und das Zentrum des kugelsymmetrischen Gegenfeldes noch annähernd zusammenfallen. Aus Gründen der Übersichtlichkeit wurde deshalb in Fig. 1 nur die von einem nicht abgelenkten Primärelektronenstrahl PE erzeugte Sekundärelektronenkeule dargestellt.

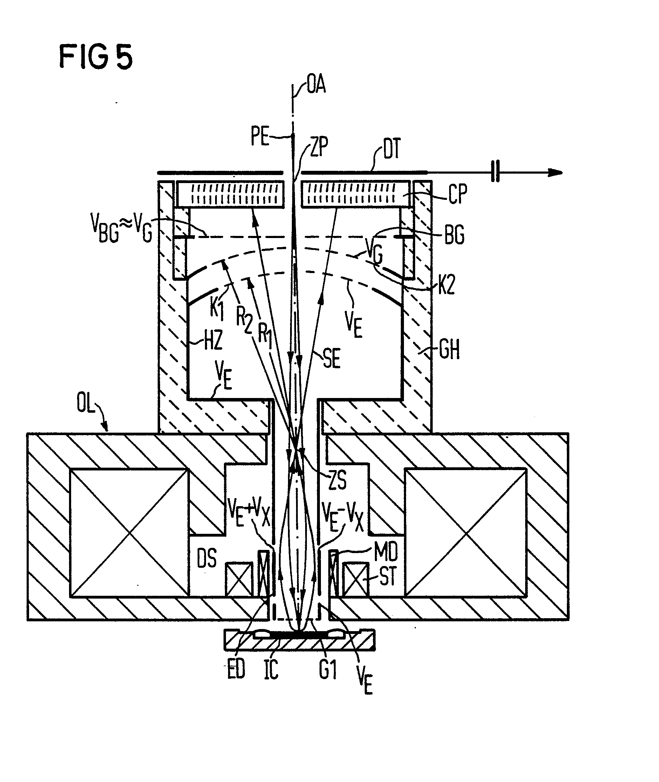

Das in Fig. 5 dargestellte Ausführungsbeispiel eines erfindungsgemäßen Spektrometerobjektivs besteht aus einer kurzbrennweitigen Objektivlinse OL, einer innerhalb der Objektivlinse OL symmetrisch zur optischen Achse OA angeordneten Ablenkeinheit DS nach Fig. 2 und 3 und einem elektrostatischen Gegenfeldspektrometer. Das aus Objektivlinse OL, Ablenkeinheit DS und Gegenfeldspektrometer bestehende System bildet die Komponente der elektronenoptischen Säule eines Elektronenstrahl-Meßgerätes, mit dem die von einer Hochstrom-Elektronenquelle emittierten Primärelektronen PE fokussiert und abgelenkt und die auf der Probe IC ausgelösten Sekundärelektronen SE in das auf der optischen Achse OA liegende Zentrum ZS des kugelsymmetrischen Gegenfeldes fokussiert werden. Das elektrische Gegenfeld wird mit Hilfe der in einem Gehäuse GH oberhalb der Objektivlinse OL angeordneten Netzelektroden K1 und K2 erzeugt, die jeweils Teile der Oberfläche konzentrischer Kugeln mit unterschiedlichen Radien $R_1$ bzw. $R_2$ ($R_1 \approx 30$ mm, $R_2 \approx 34$ mm) bilden. Da der das Zentrum des Gegenfeldes definierende Mittelpunkt ZS der den Netzelektroden K1 und K2 zugeordneten Kugeln sehr weit oberhalb der aus magnetischen und elektrischen Ablenkelementen MD bzw. ED bestehenden Ablenkeinheit DS und des Polschuhspaltes liegt, werden Larmordrehungen der Sekundärelektronen SE nach Durchlaufen des Zwischenbildes ZS vermieden. Zur Erzeugung eines von elektrischen Feldern freien Raumes im Bereich des Sekundärelektronenfokus ZS ist innerhalb des von einem ringförmigen Sekundärelektronendetektor DT abgeschlossenen Gehäuses GH, in dem sich außer den Netzelektroden K1 und K2 noch ein Abschirmgitter BG und eine Channel-Plate CP befinden, ein aus drei Teilen bestehender, symmetrisch zur optischen Achse OA angeordneter Hohlzylinder HZ vor gesehen. Während der obere Teil dieses sich im Bereich der Objektivlinse OL verjüngenden Hohlzylinders HZ leitend mit dem auf einem Potential $V_E$ liegenden Netzelektrode K1 verbunden ist, wird dessen unterer Teil probenseitig von der ebenfalls auf dem Potential $V_E$ zwischen etwa 0,5 und 5 kV, insbesondere 2 kV liegenden Netzelektrode G1 abgeschlossen. Der mittlere Zylinderteil ist wieder als elektrostatischer Achtpolablenker ED nach Fig. 2 ausgebildet, und wird von dem in Fig. 3 dargestellten magnetischen Ablenkelement MD umschlossen.

BezugszeichenlisteBG  Abschirmelektrode
CP  Channel-Plate
DE  Absaugelektrode
DS  Ablenkeinheit
DT  Detektor
ED  elektrisches Ablenkelement
F  elastische Folie
GH  Gahäuse
G1  Absaugelektrode
HZ  Hohlzylinder
IC  Probe
K1 / K2  kugelsymmetrische Elektroden
L  Arbeitsabstand
LL  Lichtleiter
MD  magnetisches Ablenkelement
OA  optische Achse
OL  Objektivlinse
PE  Primärelektronen
QS  Quellpunkt Sekundärelektronnen
$R_1$ / $R_2$  Krümmungsradien K1 bzw. K2
SE  Sekundärelektronen
ST  Stigmator
SPI / SPA  Sattelspulen SZ  Szintillator
$V_E$  Potential an G1, K2
$V_G$  Potential an K2
$V_{BG}$  Potential an BG
$V_x$ / $V_y$  Ablenkspannungen
ZP  Zwischenbild SE
ZS  Zwischenbild PE

# 0 236 807

**Ansprüche**

1. Spektrometerobjektiv für die Korpuskularstrahl-Meßtechnik mit einer Objektivlinse, einer Ablenkeinheit und einem Gegenfeldspektrometer, das eine erste Elektrodenanordnung zur Beschleunigung und eine zweite Elektrodenanordnung zur Analyse der Energie der auf einer Probe ausgelösten Sekundärkorpuskeln aufweist, wobei die Objektivlinse, die Ablenkeinheit und das Gegenfeldspektrometer eine korpuskular-optische Einheit bilden, mit der ein primärer Korpuskularstrahl fokussiert, geformt und abgelenkt wird und mit der die Sekundärkorpuskeln in Richtung der Objektivlinse beschleunigt werden **gekennzeichnet** durch eine einstufige Ablenkeinheit (DS) die mindestens ein ein nahezu homogenes elektrisches Ablenkfeld erzeugendes elektrisches Ablenkelement (ED) und mindestens ein ein nahezu homogenes magnetisches Ablenkfeld erzeugendes magnetisches Ablenkelement (MD) aufweist, wobei die von den Ablenkelementen (ED, MD) erzeugten elektrischen und magnetischen Ablenkfelder räumlich so zueinander orientiert sind, daß deren Feldvektoren ($\vec{E}$, $\vec{B}$) nahezu senkrecht aufeinander und jeweils nahezu senkrecht auf dem Geschwindigkeitsvektor ($\vec{V}_{SE}$) der von der Probe (IC) abgesaugten und in Richtung des Spektrometerobjektivs beschleunigten Sekundärkorpuskeln (SE) stehen und die Feldstärken ($\vec{E}$, $\vec{B}$) der gekreuzten elektrischen und magnetischen Ablenkfelder so aufeinander abgestimmt sind, daß der Quotient ($E_o/B_o$) aus dem Betrag der elektrischen und dem Betrag der magnetischen Feldstärke näherungsweise konstant und dem Betrag der Geschwindigkeit der Sekundärkorpuskeln (SE) nach Durchlaufen der ersten Elektrodenanordnung (G1) gleich ist.

2. Spektrometerobjektiv nach Anspruch 1, dadurch **gekennzeichnet**, daß die Ablenkeinheit (DS) so innerhalb der Objektivlinse (OL) angeordnet ist, daß deren Ablenkhauptebene mit der bildseitigen Hauptebene der Objektivlinse (OL) nahezu übereinstimmt.

3. Spektrometerobjektiv nach Anspruch 1 oder 2 **gekennzeichnet** durch ein elektrostatisches Ablenkelement (ED) mit mehreren, auf unterschiedlichem Potential liegenden und symmetrisch zur optischen Achse (OA) angeordneten Elektroden.

4. Spektrometerobjektiv nach einem der Ansprüche 1 bis 3, dadurch **gekennzeichnet**, daß die Elektroden des elektrischen Ablenkelementes (ED) Teile der Mantelfläche eines konzentrisch zur optischen Achse (OA) angeordneten Hohlzylinders (HZ) bilden.

5. Spektrometerobjektiv nach einem der Ansprüche 1 bis 4 **gekennzeichnet** durch einen elektrostatischen Achtpolablenker als elektrisches Ablenkelement (ED).

6. Spektrometerobjektiv nach einem der Ansprüche 1 bis 5 **gekennzeichnet** durch ein magnetisches Ablenkelement (MD) aus mindestens zwei symmetrisch zur optischen Achse (OA) angeordneten Sattelspulenpaaren (SPI, SPA).

7. Spektrometerobjektiv nach einem der Ansprüche 1 bis 6, dadurch **gekennzeichnet**, daß die einzelnen Sattelspulen Teile der Mantelfläche eines konzentrisch zur optischen Achse (OA) angeordneten Hohlzylinders bilden.

8. Spektrometerobjektiv nach einem der Ansprüche 1 bis 7, dadurch **gekennzeichnet**, daß die Leiterbahnen (LB) der Sattelspulen in einer flexiblen Folie (Fl, FA) eingebettet sind.

9. Spektrometerobjektiv nach einem der Ansprüche 1 bis 8, dadurch **gekennzeichnet**, daß bei jeder der Sattelspulen die Zahl der Windungen pro Winkeleinheit in einer Ebene senkrecht zur optischen Achse - (OA) eine Kosinus-oder Sinusverteilung aufweist.

10.Spektrometerobjektiv nach einem der Ansprüche 1 bis 9, dadurch **gekennzeichnet**, daß innerhalb der Objektivlinse (OL) ein in drei parallel zueinander und senkrecht zur optischen Achse (OA) liegenden Ebenen unterteilter, und konzentrisch zur optischen Achse (OA) angeordneter Hohlzylinder (HZ) vorgesehen ist, dessen probenseitiger Teil von der ersten Elektrodenanordnung (G1) abgeschlossen wird, dessen mittlerer, das elektrische Ablenkelement (ED) bildender Teil aus mehreren auf unterschiedlichem Potential ($V_i$) liegenden Elektroden besteht und dessen oberer Teil von der zweiten Elektrodenanordnung (K1, K2) abgeschlossen wird.

11.Spektrometerobjektiv nach einem der Ansprüche 1 bis 10, dadurch **gekennzeichnet**, daß das magnetische Ablenkelement (MD) den mittleren Teil des Hohlzylinders ringförmig umfasst.

12.Spektrometerobjektiv nach einem der Ansprüche 1 bis 11, dadurch **gekennzeichnet**, daß die Feldverteilung des elektrischen Ablenkfeldes über die in Richtung der optischen Achse (OA) gemessenen Abstände ($d_1$, $d_2$) und/oder die Längen ($l_1$, L, $l_2$) des unteren, mittleren und oberen Teils des Hohlzylinders - (HZ) einem vorgegebenen magnetischen Ablenkfeldverlauf angepaßt ist.

13.Spektrometerobjektiv nach einem der Ansprüche 1 bis 12, dadurch **gekennzeichnet**, daß die zweite Elektrodenanordnung (K1, K2) vollständig innerhalb der Objektivlinse (OL) angeordnet ist.

14. Spektrometerobjektiv nach einem der Ansprüche 1 bis 12, dadurch **gekennzeichnet,** daß die zweite Elektrodenanordnung (K1, K2) oberhalb der Objektivlinse (OL) angeordnet ist.

15. Spektrometerobjektiv nach einem der Ansprüche 1 bis 14, dadurch **gekennzeichnet,** daß die zweite Elektrodenanordnung (K1, K2) zwei Elektroden (K1, K2) aufweist, die jeweils Teile der Oberfläche konzentrischer Kugeln mit unterschiedlichen Radien ($R_1$, $R_2$) bilden und mit Spannungen ($V_E$, $V_G$) derart beaufschlagt sind, daß sich im Raumbereich zwischen diesen Elektroden ein die Sekundärkorpuskeln (SE) abbremsendes Gegenfeld aufbaut, daß die Mittelpunkte der den beiden Elektroden (K1, K2) zugeordneten Kugeln in einem oberhalb der Ablenkeinheit (DS) auf der optischen Achse (OA) liegenden Punkt (ZS) zusammenfallen, daß dieser das Zentrum des kugelsymmetrischen Gegenfeldes definierende Punkt (ZS) in einem nahezu feldfreien Raumbereich liegt und mit dem Punkt zusammenfällt, in den die im Feld der ersten Elektrodenanordnung (G1) beschleunigten Sekundärkorpuskeln (SE) fokussiert werden.

16. Spektrometerobjektiv nach einem der Ansprüche 1 bis 13 **gekennzeichnet** durch einen konzentrisch zur optischen Achse (OA) und oberhalb der zweiten Elektrodenanordnung (K1, K2) angeordneten ringförmigen Detektor (DT) zum Nachweis der Sekundärkorpuskeln (SE).

17. Spektrometerobjektiv nach einem der Ansprüche 1 bis 16 **gekennzeichnet** durch eine zwischen der zweiten Elektrodenanordnung (K1, K2) und dem Detektor (DT) angeordnete Gitterelektrode (BG).

# FIG 1

FIG 2

FIG 3

# FIG 4

# FIG 5